# EUROPEAN PATENT APPLICATION

(11) **EP 4 618 358 A1**
(43) Date of publication of application: **17.09.2025**
(21) Application number: 23888727.7
(22) Date of filing: 08.11.2023
(51) Int. Cl.: H02J 7/00, G01R 31/367, G01R 31/382, G01R 31/385, G01R 31/392, G01R 31/396, H01M 10/48, H02J 7/04

(54) **BATTERY MONITORING PROGRAM, RECORDING MEDIUM, AND BATTERY MONITORING SYSTEM**

(30) Priority: 10.11.2022 JP 2022180268
(71) Applicant: DENSO CORPORATION, Kariya-city, Aichi-pref., 448-8661 (JP)
(72) Inventor: KUSANO, Yoshikazu, Kariya-city, Aichi pref., 448-8661 (JP); YAMAMOTO, Nobuo, Kariya-city, Aichi pref., 448-8661 (JP); SUZUKI. Shogo, Kariya-city, Aichi pref., 448-8661 (JP); MIZUNO, Yuki, Kariya-city, Aichi pref., 448-8661 (JP); SHIBATA Daisuke, Kariya-city, Aichi pref., 448-8661 (JP); TANI, Keiya, Kariya-city, Aichi pref., 448-8661 (JP)
(74) Representative: Winter, Brandl - Partnerschaft mbB
(86) International application number: PCT/JP2023/040170
(87) International publication number: WO 2024/101380

(57) **Abstract**

A battery monitoring program (P1) is configured to cause at least one processor (1) to set a usage condition (U) of a secondary battery (2) based on a degradation factor (F) of the secondary battery (2). A battery monitoring system (100) to monitor a secondary battery (2) includes a usage condition setting unit (104) configured to set a usage condition (U) of the secondary battery (2) based on a degradation factor (F) of the secondary battery (2).

## Description

### CROSS REFERENCE TO RELATED APPLICATIONS

This application is based on Japanese Patent Application No. 2022-180268 filed on November 10, 2022, the disclosure of which is incorporated herein by reference.

### TECHNICAL FIELD

The present disclosure relates to techniques for monitoring a battery.

### BACKGROUND

The Patent Literature 1 discloses a technology that utilizes an array of electric energy storage devices such as a battery pack. In this technology, for example, battery packs are classified based on their battery characteristics, and battery packs having the same battery characteristics are used simultaneously at a usage destination. Battery characteristics include usage period, electrical resistance, remaining capacity, estimated service life, and the like. This technology is expected to maximize the battery performance of each battery pack by simultaneously using battery packs with the same battery characteristics.

### PRIOR ART LITERATURE

### PATENT LITERATURE

Patent Literature 1: JP 2017-509867 A

### SUMMARY

The battery pack includes multiple secondary batteries. There are various factors that cause degradation in secondary batteries. Thus, even if multiple secondary batteries having the same battery performance are started to be used, as in the technology described in Patent Literature 1, if the factors that cause degradation in the secondary batteries are different, continued use of the secondary batteries will result in variations in the battery performance (i.e., the service life) of the secondary batteries. This makes it difficult to use the secondary batteries efficiently.

The present disclosure aims to provide a battery monitoring technique that is effective for efficient use of secondary batteries.

According to an aspect of the present disclosure, a battery monitoring program configured to cause at least one processor to set a usage condition of a secondary battery based on a degradation factor of the secondary battery is provided.

According to another aspect of the present disclosure, a recording medium configured to store the battery monitoring program in a readable manner is provided.

According to yet another aspect of the present disclosure, a battery monitoring system to monitor a secondary battery including a usage condition setting unit is provided. The battery monitoring system is configured to set a usage condition for a secondary battery based on a degradation factor of the secondary battery.

According to each of the above-mentioned aspects, it is possible to extend the service life of the secondary battery and increase the operating rate, thereby enabling the secondary battery to be used efficiently.

The reference numerals in parentheses described in the claims indicate the correspondence relationship with the specific means described in the embodiments described later, and do not limit the technical scope of the present disclosure.

### BRIEF DESCRIPTION OF THE DRAWINGS

The above and other objects, features and advantages of the present disclosure will become more apparent from the following detailed description made with reference to the accompanying drawings. In the drawings:
FIG. 1 is a block diagram showing the configuration of a battery monitoring system according to a first embodiment;
FIG. 2 is a flowchart showing a usage condition setting control executed by a battery monitoring system of the first embodiment;
FIG. 3 is a block diagram showing the configuration of a battery monitoring system according to a second embodiment;
FIG. 4 is a block diagram showing the configuration of a battery monitoring system according to a third embodiment;
FIG. 5 is a block diagram showing the configuration of a battery monitoring system according to a fourth embodiment;
FIG. 6 is a block diagram showing the configuration of a battery monitoring system according to a fifth embodiment;
FIG. 7 is a block diagram showing the configuration of a battery monitoring system according to a sixth embodiment;
FIG. 8 is a block diagram showing the configuration of a battery monitoring system according to a seventh embodiment;
FIG. 9 is a block diagram showing the configuration of a battery monitoring system according to an eighth embodiment;
FIG. 10 is a block diagram showing the configuration of a battery monitoring system according to a ninth embodiment; and
FIG. 11 is a block diagram showing the configuration of a battery monitoring system including a display program.

### DESCRIPTION OF EMBODIMENTS

Hereinafter, a battery monitoring technology according to the above-mentioned embodiments will be described in detail with reference to the drawings.

### (First embodiment)

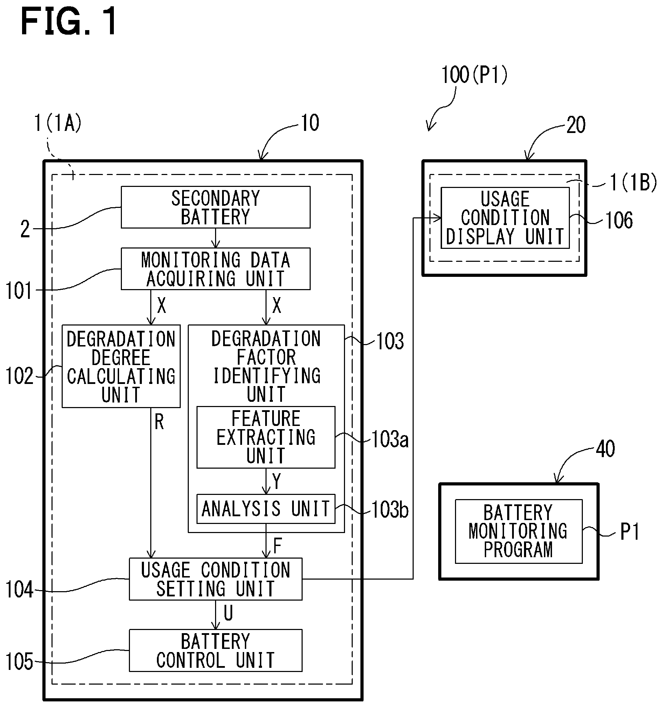

As shown in FIG. 1, a battery monitoring system 100 according to the first embodiment is a system to monitor a secondary battery 2 constituting a battery mounted on a vehicle 10 such as an electric vehicle or a hybrid vehicle. The secondary battery 2 is a battery assembly formed of multiple battery cells. The secondary battery 2, together with a Battery Management Unit (i.e., BMU), forms a so-called "battery pack," and the BMU includes a monitoring data acquiring unit 101, a degradation degree calculating unit 102, a degradation factor identifying unit 103, a usage condition setting unit 104, and a battery control unit 105, which will be described later. The secondary battery 2 (i.e., the battery pack) may be of a replaceable type (cartridge type) that is removably mounted on the vehicle 10, or may be of a fixed type that is non-removably mounted on the vehicle 10.

The battery monitoring system 100 includes, as its components, the monitoring data acquiring unit 101, the degradation degree calculating unit 102, the degradation degree identifying unit 103, the usage condition setting unit 104, the battery control unit 105, and a usage condition display unit 106. The functions of these components are executed by processors 1 (processors 1A, 1B) provided in the battery pack of the vehicle 10 and in the charging station 20, respectively.

The charging station 20 is a facility configured to perform at least charging operation of the secondary battery 2 mounted on the vehicle 10. In the charging station 20, the secondary battery 2 may be charged with being mounted on the vehicle 10, or with being removed from the vehicle 10. The secondary battery 2 having been charged may be used again in the vehicle 10, or in another vehicle, or may be reused in a secondary usage destination other than the vehicle 10. Furthermore, the charging station 20 may be provided with additional equipment for performing replacement work of the secondary battery 2, or the charging station 20 may be replaced with an exchange station where at least replacement work of the secondary battery 2 can be performed.

The function of each component of the battery monitoring system 100 is realized by a battery monitoring program P1. The battery monitoring program P1 is a program configured to cause the processors 1 to realize at least function of acquiring monitoring data X of the secondary battery, function of calculating the degradation degree of the secondary battery 2 based on the monitoring data X, function of identifying a degradation factor F of the secondary battery 2 based on the monitoring data X, function of setting a usage condition U of the secondary battery 2 based on the calculation result of the degradation degree, and function of displaying the usage condition U. The battery monitoring program P1 is preferably recorded in a readable manner on the recording medium 40 as necessary. The "recording" here can also be called "storage." As the recording medium 40, various types such as a memory type, a disk type, and a tape type may be used.

In the drawings relating to this embodiment, the recording medium 40 is illustrated separately from the vehicle 10, the charging station 20, and a battery monitoring server 30, which will be described later. However, the recording medium 40 is included in at least one of these components. In the drawings, the recording medium 40 is shown separately from the above-mentioned components in order to avoid complicated or limited representation of the recording location of the battery monitoring program.

The "processor 1" referred to here broadly includes processing devices, among components of a computer, that perform operations such as data calculations and conversions, program execution, and control of other devices. Typically, the processor 1 is composed of a Central Processing Unit (i.e., CPU), which controls the entire computer, or a Micro Processing unit (i.e., MPU), which integrates some of the functions of the CPU.

In this embodiment, the processor 1A mounted on the BMU in the battery pack executes the functions of the monitoring data acquiring unit 101, the degradation degree calculating unit 102, the degradation factor identifying unit 103, the usage condition setting unit 104, and the battery control unit 105. The processor 1B installed in the charging station 20 executes the function of the usage condition display unit 106.

The allocation of the multiple components (functional elements) of the battery monitoring system 100 between the vehicle 10 and the charging station 20 is not limited to that shown in FIG. 1, and can be changed appropriately as necessary.

The monitoring data acquiring unit 101 has a function of acquiring monitoring data X of the secondary battery 2. The data may be sensed directly from the secondary battery 2, or may be data converted as history information from the sensed data by a control unit or the like. As the monitoring data X, time series data of voltage, charge/discharge current, State of Charge (i.e., SOC), battery temperature, ambient temperature around the battery, cumulative charging time, cumulative discharging time, cumulative current, alternating current impedance, and the like may be used. Furthermore, as the monitoring data for the battery assembly, time-series data of the total voltage of the battery assembly, the maximum and/or minimum voltage, temperature, and the SOC of the secondary batteries in the battery assembly may be used. The "voltage" here includes open-circuit voltage and closed-circuit voltage. The monitoring data acquiring unit 101 may be a sensor capable of detecting the monitoring data X to be acquired, such as a voltage sensor, a current sensor, and a temperature sensor, and the SOC is calculated based on these values.

The degradation degree calculating unit 102 has a function of calculating the degradation degree of the secondary battery 2 based on the monitoring data X acquired by the monitoring data acquiring unit 101. According to the degradation degree calculating unit 102, when an evaluation parameter such as the capacity or internal resistance of the secondary battery 2 is selected from the monitoring data X, the degradation degree is calculated from the value of the evaluation parameter. Then, a calculation result R is derived which indicates whether the degradation degree exceeds a preset threshold value. If the degradation degree exceeds the threshold value, a calculation result R is obtained indicating that the secondary battery 2 has deteriorated to a predetermined level. On the other hand, when the degradation degree is equal to or less than the threshold value, a calculation result R is obtained indicating that the degradation degree of the secondary battery 2 is low.

The degradation factor identifying unit 103 has a function of identifying a degradation factor F based on the monitoring data X. The degradation factor identifying unit 103 includes a feature extracting unit 103a and an analysis unit 103b. The feature extraction unit 103a extracts a feature Y to be used by the analysis unit 103b from the monitoring data X. The feature Y may be at least one of accumulated information of a parameter acquired as the monitoring data X, fluctuation information of the parameter, and simultaneous frequency information of multiple parameters. Typical parameters include voltage, SOC, temperature, and current. The analysis unit 103b executes an analysis process using the feature Y extracted by the feature extracting unit 103a to derive the degradation factor F.

The usage condition setting unit 104 has a function of setting a usage condition U of the secondary battery 2 based on the calculation result R obtained by the degradation degree calculating unit 102 and the degradation factor F derived by the analysis unit 103b. The usage condition U of the secondary battery 2 include, for example, a charging condition, an input/output condition, a SOC usage condition, a temperature adjustment condition, a usage condition, a usage area condition, a usage order condition, a battery combination condition.

The battery control unit 105 has a function of controlling the secondary battery 2 based on the usage condition U set by the usage condition setting unit 104.

The usage condition display unit 106 has a function of displaying the usage condition U set by the usage condition setting unit 104. The usage condition U is preferably displayed on the screen of a device, such as a desktop or notebook personal computer (i.e., PC), a tablet terminal, or a mobile terminal.

In this embodiment, the location where the usage condition display unit 106 is provided is not limited to the charging station 20. Instead of or in addition to the charging station 20, for example, the usage condition display unit 106 may be provided at a secondary usage destination of the secondary battery 2.

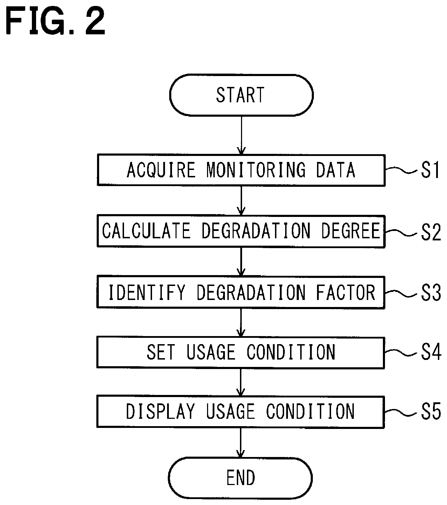

Next, the usage condition setting control by the battery monitoring system 100 will be described with reference to FIG. 2. The usage condition setting control is achieved by sequentially executing steps S1 to S5 in FIG. 2. It should be noted that one or more steps may be added to these steps as necessary, or multiple steps may be appropriately integrated.

As shown in FIG. 2, step S1 is a step in which the monitoring data acquiring unit 101 (see FIG. 1) acquires monitoring data X of the secondary battery 2. According to step S1, monitoring data X of the secondary battery 2 is acquired. Step S2 is a step in which the degradation degree calculating unit 102 (see FIG. 1) calculates the degradation degree of the secondary battery 2 based on the monitoring data X acquired in step S1. In step S2, the calculation result R of the degradation degree of the secondary battery 2 is derived according to the detailed inspection as described above.

Step S3 is a step in which the degradation factor identifying unit 103 (see FIG. 1) identifies a degradation factor F of the secondary battery 2 through an analysis process. In step S3, the degradation factor F of the secondary battery 2 is identified. The "deterioration factor F" here refers to a feature Y that, among multiple features Y, degrades the secondary battery 2. The number of degradation factors F identified through the analysis process is not particularly limited. The degradation factor identifying unit 103 may identify one or more degradation factors F. When there are multiple degradation factors F, the degradation factor F that has the greatest influence can be determined as the main factor among the degradation factors F.

In step S3, first, the feature extracting unit 103a (see FIG. 1) extracts a feature Y from the monitoring data X (see FIG. 1). Then, the analysis unit 103b derives a degradation factor F from the extracted feature Y. Note that step S3 may be executed subsequent to step S2, before step S2, or simultaneously with step S2.

As an example of the analysis method at this time, the amount of the feature Y is multiplied by the degree of influence of the feature Y on the degradation of the secondary battery 2 to obtain a value, which is defined as a damage amount. The damage amount caused by each of the multiple features Y is calculated and compared, and the feature Y with the greatest damage amount can be identified as the degradation factor F.

In this analysis method, the degree of influence of each feature Y is set in advance based on the characteristics of a degraded battery. For example, the degree of influence of the feature Y is defined as its contribution level (importance) in a model. This model is created by setting the degradation degrees of multiple degraded batteries as the objective variable and each feature Y as the explanatory variable, and performing multivariate analysis. It is desirable to standardize each feature Y as an explanatory variable in order to fairly compare the contribution level (importance) of each feature Y.

Step S4 is a step in which the usage condition setting unit 104 sets a usage condition of the secondary battery 2. According to step S4, the usage condition U of the secondary battery 2 is set based on both the calculation result R derived in step S2 and the degradation factor F identified in step S3.

Here, an example of the usage condition U will be given. It is preferable that the usage condition U be set appropriately in each of the following cases: when the battery pack is fixed to the vehicle 10 (hereinafter referred to as "Case 1"), when an operation service for operating multiple vehicles 10 is adopted (hereinafter referred to as "Case 2"), when the battery pack is replaceable with respect to the vehicle 10 (hereinafter referred to as "Case 3"), and when the battery pack is reused in a secondary use destination other than the vehicle 10 (hereinafter referred to as "Case 4").

### <Case 1>

As the usage condition U in Case 1, typically, a charging condition, an input/output condition, a SOC usage condition, and a temperature adjustment condition can be set. The charging condition may involve reducing the current value of the secondary battery 2 during charging or increasing the upper limit voltage during charging to prevent further degradation caused by the identified degradation factor F. The input/output condition may involve restricting the upper limit of the input/output of the secondary battery 2. The SOC use condition may involve narrowing the SOC usage range of the secondary battery 2. The temperature adjustment condition may involve increasing the cooling capacity or the heating capacity for the secondary battery 2. Since the usage conditions to be changed are determined according to the degradation factor F, it is possible to avoid unnecessarily restricting the battery's performance.

### <Case 2>

As the usage condition U in Case 2, typically, a usage condition, a usage area condition, and a usage order condition can be set. The usage condition may involve allocating the vehicles 10 each equipped with the secondary battery 2 based on the required driving distance, the required input/output power for the secondary battery 2, or the required operating time for the secondary battery 2, to level out the degradation factor F. The usage area condition may involve allocating the vehicles 10 each equipped with the secondary battery 2 based on the ambient temperature of the area, the driving distance required in the area, the use of the input/output power required for the secondary battery 2 in the area, or the operating time required for the secondary battery 2 in the area to level out the deterioration factor F. The usage order condition may involve determining the order of charging the secondary batteries 2 or the order of use to level out the deterioration factor F.

### <Case 3>

As the usage condition U in Case 3, typically, a usage condition, a usage area condition, a usage order condition, and a battery combination condition can be set. The usage condition may involve allocating the vehicles 10 each equipped with the secondary battery 2 based on the required driving distance, the required input/output power for the secondary battery 2, or the required operating time for the secondary battery 2, to level out the degradation factor F. The usage area condition may involve allocating the vehicles 10 each equipped with the secondary battery 2 based on the ambient temperature of the area, the driving distance required in the area, the use of the input/output power required for the secondary battery 2 in the area, or the operating time required for the secondary battery 2 in the area to level out the deterioration factor F. The usage order condition may involve determining the order of charging the secondary batteries 2 or the order of use to level out the deterioration factor F. The battery combination condition may involve, when multiple secondary batteries 2 are mounted on the vehicle 10, combining the multiple secondary batteries 2 to have the same or similar degradation factor F.

A specific example of the relationship between the degradation factor F and the usage condition U in the above cases 1 to 3 will be described. For example, if the degradation factor F is high temperature or high SOC, the usage conditions U corresponding to this degradation factor F may be installing the secondary battery 2 in a room temperature or low temperature area, improving the cooling performance for the secondary battery 2, or lowering the center of SOC fluctuation. In addition, if the degradation factor F is low temperature or large current, the usage conditions U corresponding to this degradation factor F may be installing the secondary battery 2 in a room temperature or high temperature area, improving the heating capacity of the secondary battery 2, or limiting the input performance at low temperatures. Furthermore, if the degradation factor F is a high average SOC or a large fluctuation range of the SOC, the usage conditions U corresponding to this degradation factor F may be installing the secondary battery 2 in an area where the secondary battery 2 is used infrequently, using the secondary battery 2 only when the vehicle 10 is traveling short distances, or limiting the fluctuation range of the SOC. It should be noted that the relationship between the degradation factors F and the usage conditions U is merely illustrative and is not limited to the relationships described above.

Furthermore, when the secondary battery 2 is replaceable, the specific charging station 20 in which the secondary battery 2 is placed can be selected from multiple charging stations 20 based on the degradation factor F of the battery. At this time, it is preferable to classify the charging stations 20 such that each charging station 20 accommodates the secondary batteries 2 having the same or the same type of degradation factors F. This makes it possible to determine the charging station 20 as a placement for the secondary battery 2 so that the deterioration factors F are leveled out. The charging stations 20 may be classified in advance, or in real time based on information about the secondary batteries 2.

### <Case 4>

When the degradation factor F is leveled out by stationary use, the usage condition U in Case 4 may involve allocating the secondary battery 2 for reuse. Further, in the case of reuse, the usage condition U may involve allocating the secondary batteries 2 based on the usage and the usage area to level out the degradation factor F. Similarly, when the deterioration factor F is leveled out by changing the usage and the usage area in the case of rebuilding, the usage condition U may involve allocating the secondary battery 2 for rebuilding. The change of the usage in rebuilding may be a change from EV (electric vehicle) to HV (hybrid vehicle), or from long-distance use to short-distance use.

Step S5 is a step in which the usage condition display unit 106 (see FIG. 1) displays the usage condition U set in step 4. According to step S5, the usage condition U of the secondary battery 2 is displayed on the usage condition display unit 106. In this embodiment, since the charging station 20 includes the usage condition display unit 106, the usage condition U can be confirmed at the charging station 20.

According to the first embodiment, the following effects are obtained.

In the first embodiment, a process of setting the usage condition U of the secondary battery 2 based on at least the degradation factor F of the secondary battery 2 is executed. This makes it possible to prevent the secondary battery 2 from rapidly degrading due to a specific degradation mechanism. As a result, the service life of the secondary battery 2 can be extended and the operating rate can be increased, making it possible to use the secondary battery 2 efficiently.

In particular, in the first embodiment, the usage condition U is set based on both the calculation result R of the degradation degree and the degradation factor F. Thus, compared to the case where the usage condition U is set based only on the calculation result R of the degradation degree, the following advantageous effects are achieved. When the usage condition U is set based solely on the calculation result R of the degradation degree, it would be necessary to uniformly impose usage restrictions on multiple parameters related to the use of the secondary battery 2. However, it is possible to narrow down the number of parameters to which usage restrictions are imposed by additionally considering the degradation factor F. Thus, it is possible to propose more optimal usage conditions U for the secondary battery 2.

Hereinafter, other embodiments related to the above-described first embodiment will be described with reference to the drawings. In other embodiments, the same elements as those in the first embodiment are denoted by the same reference numerals, and the description of the same elements is omitted.

### (Second Embodiment)

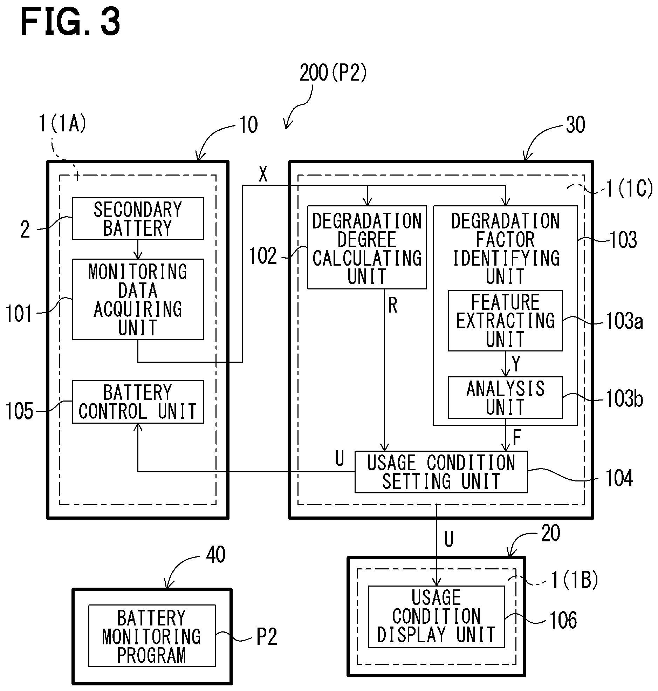

As shown in FIG. 3, the battery monitoring system 200 of the second embodiment differs from the battery monitoring system 100 of the first embodiment in that the degradation degree calculating unit 102, the degradation factor identifying unit 103, and the usage condition setting unit 104 are provided in the battery monitoring server 30 instead of the battery pack on the vehicle 10. The battery monitoring server 30 is a facility for providing a monitoring service for the secondary battery 2. The battery monitoring server 30 may be installed adjacent to the charging station 20 or may be installed at a location away from the charging station 20.

The functions of each component of the battery monitoring system 200 are realized by a battery monitoring program P2. The battery monitoring program P2 is a program configured to cause the processors 1 (processors 1A, 1B, 1C) provided in each of the battery pack in the vehicle 10, the charging station 20, and the battery monitoring server 30 to realize functions similar to those of the battery monitoring program P1 of the first embodiment. The battery monitoring program P2 is preferably recorded on the recording medium 40 in a readable manner as necessary.

The other configurations are the same as those of the first embodiment.

According to the second embodiment, the functions of the degradation degree calculating unit 102, the degradation factor identifying unit 103, and the usage condition setting unit 104 are executed in the battery monitoring server 30, thereby reducing the processing load on the battery pack compared to the first embodiment.

In addition, this embodiment has the same functions and advantages as in the first embodiment.

### (Third Embodiment)

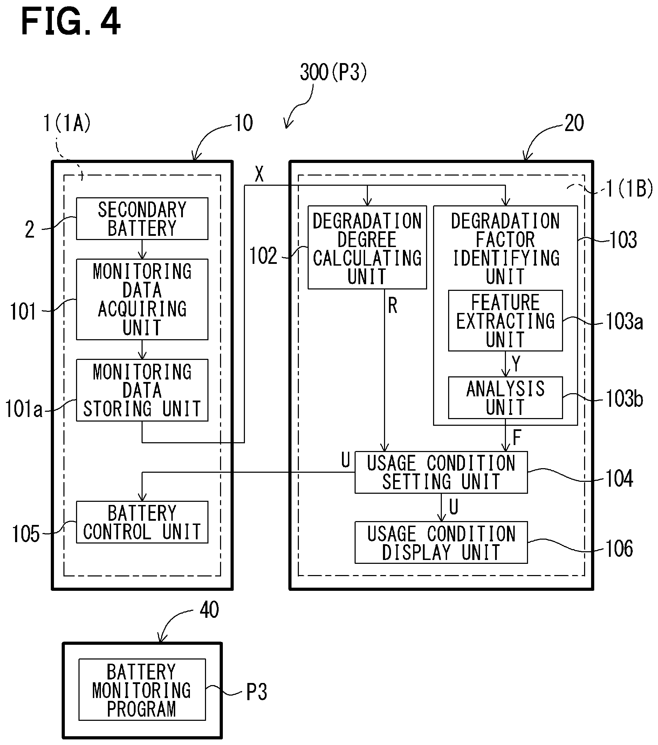

As shown in FIG. 4, a battery monitoring system 300 of the third embodiment differs from the battery monitoring system 200 of the second embodiment in that the battery pack in the vehicle 10 further includes a monitoring data storage unit 101a, and the degradation degree calculating unit 102, the degradation degree identifying unit 103, the usage condition setting unit 104 and the usage condition display unit 106 are provided in the charging station 20 instead of the battery monitoring server 30. The monitoring data storage unit 101a has a function of storing the monitoring data X acquired by the monitoring data acquiring unit 101 before outputting the data to the degradation degree calculating unit 102 and the degradation factor identifying unit 103 of the charging station 20.

The function of each component of the battery monitoring system 300 is realized by a battery monitoring program P3. The battery monitoring program P3 is a program configured to cause the processors 1 (processors 1A and 1B) to realize functions similar to those of the battery monitoring program P2 of the second embodiment. The battery monitoring program P3 is preferably recorded on the recording medium 40 in a readable manner as necessary.

The other configurations and the control are the same as those of the second embodiment.

According to the third embodiment, the monitoring data X temporarily stored in the monitoring data storage unit 101a can be output to the charging station 20 at a timing when the vehicle 10 or the battery pack arrives at the charging station 20. Alternatively, the monitoring data X temporarily stored in the monitoring data storage unit 101a can be constantly output to the charging station 20 by a data transmission/reception function between the vehicle 10 and the charging station 20. Furthermore, according to the third embodiment, the functions executed by the battery monitoring server 30 in the second embodiment can be consolidated into the charging station 20.

In addition, this embodiment has the same functions and advantages as in the second embodiment.

### (Fourth Embodiment)

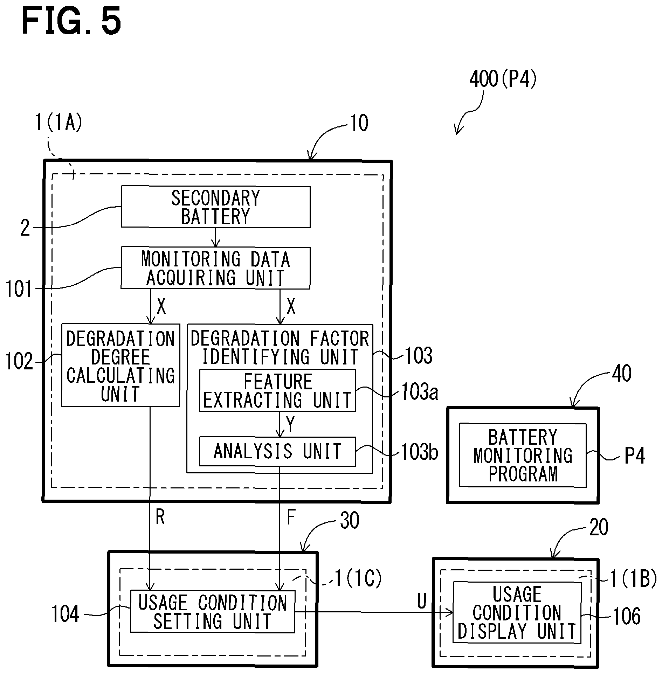

As shown in FIG. 5, a battery monitoring system 400 of the fourth embodiment differs from the battery monitoring system 200 of the second embodiment in that the degradation degree calculating unit 102 and the degradation factor identifying unit 103 are provided in the battery pack of the vehicle 10 instead of the battery monitoring server 30. The battery monitoring system 400 is preferably used in an operation service for operating multiple vehicles 10.

The function of each component of the battery monitoring system 400 is realized by a battery monitoring program P4. The battery monitoring program P4 is a program configured to cause the processors 1 (processors 1A, 1B, 1C) to realize functions similar to those of the battery monitoring program P2 of the second embodiment. The battery monitoring program P4 is preferably recorded on the recording medium 40 in a readable manner as necessary.

In this embodiment, the location where the usage condition display unit 106 is provided is not limited to the charging station 20. Instead of or in addition to the charging station 20, the usage condition display unit 106 may be provided, for example, at a secondary user of the secondary battery 2 or for the administrator of the operation service that operates the vehicles 10.

The other configurations and the control are the same as those of the second embodiment.

According to the fourth embodiment, among the functions executed in the battery monitoring server 30 in the second embodiment, all functions other than the function of the usage condition setting unit 104 can be consolidated into the battery pack of the vehicle 10.

In addition, this embodiment has the same functions and advantages as in the second embodiment.

### (Fifth Embodiment)

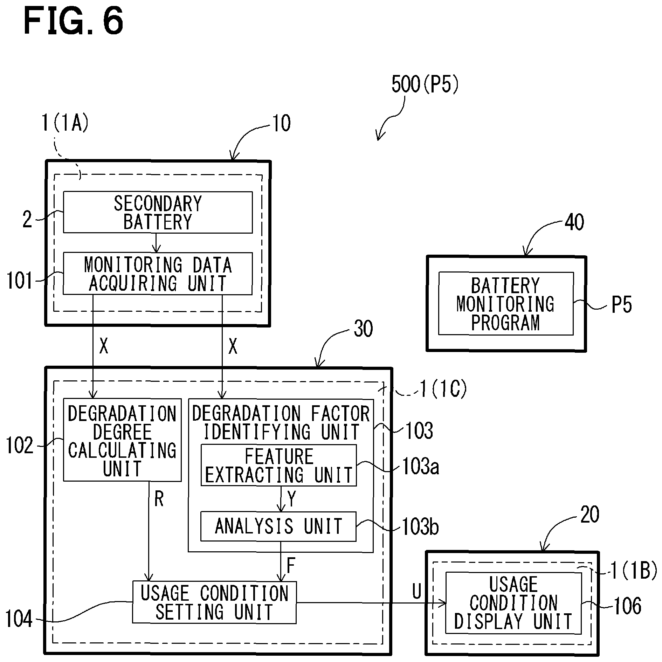

As shown in FIG. 6, a battery monitoring system 500 of the fifth embodiment differs from the battery monitoring system 400 of the fourth embodiment in that the degradation degree calculating unit 102 and the degradation factor identifying unit 103 are provided in the battery monitoring server 30 instead of the battery pack of the vehicle 10. This battery monitoring system 500 is preferably used in an operation service for operating multiple vehicles 10.

The function of each component of the battery monitoring system 500 is realized by a battery monitoring program P5. The battery monitoring program P5 is a program configured to cause the processors 1 (processors 1A, 1B, 1C) to realize functions similar to those of the battery monitoring program P4 of the fourth embodiment. The battery monitoring program P5 is preferably recorded on the recording medium 40 in a readable manner as necessary.

The other configurations and the control are the same as those of the fourth embodiment.

According to the fifth embodiment, among the functions executed by the battery pack of the vehicle 10 in the fourth embodiment, all functions other than the function of the monitoring data acquiring unit 101 can be consolidated into the battery monitoring server 30.

According to the fifth embodiment, the functions of the degradation degree calculating unit 102, the degradation factor identifying unit 103, and the usage condition setting unit 104 are executed in the battery monitoring server 30, thereby reducing the processing load on the battery pack compared to the fourth embodiment.

In addition, this embodiment has the same functions and advantages as in the fourth embodiment.

### (Sixth Embodiment)

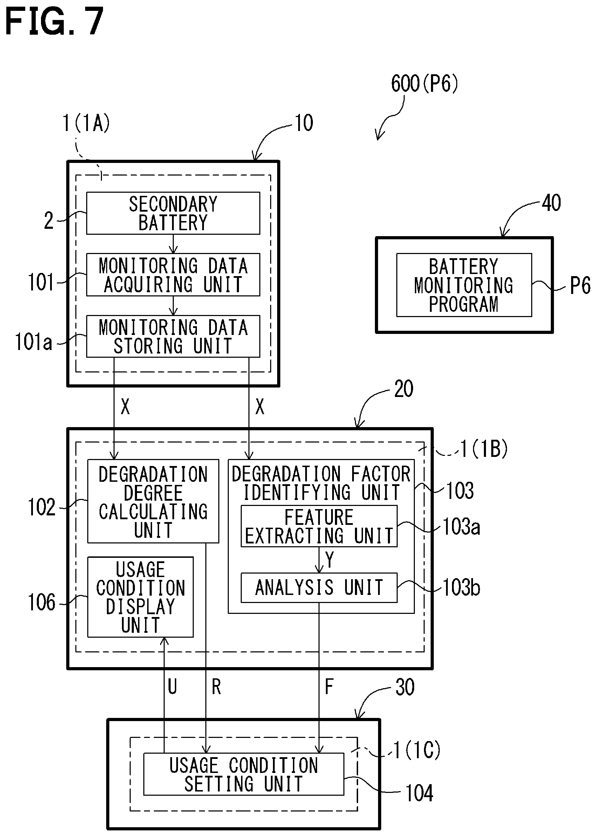

As shown in FIG. 7, a battery monitoring system 600 of the sixth embodiment differs from the battery monitoring system 500 of the fifth embodiment in that the battery pack in the vehicle further includes the monitoring data storage unit 101a, and the degradation degree calculating unit 102 and the degradation degree identifying unit 103 are provided in the charging station 20 instead of the battery monitoring server 30. The monitoring data storage unit 101a has a function of storing the monitoring data X acquired by the monitoring data acquiring unit 101 before the data is output to the degradation degree calculating unit 102 and the degradation factor identifying unit 103 of the battery monitoring server 30. The battery monitoring system 600 is preferably used in an operation service that operates multiple vehicles 10 or in operating replaceable batteries.

The function of each component of the battery monitoring system 600 is realized by a battery monitoring program P6. The battery monitoring program P6 is a program configured to cause the processors 1 (processors 1A, 1B, 1C) to realize functions similar to those of the battery monitoring program P5 of the fifth embodiment. The battery monitoring program P6 is preferably recorded on the recording medium 40 in a readable manner as necessary.

The other configurations and the control are similar to those of the fifth embodiment.

According to the sixth embodiment, among the functions executed in the battery monitoring server 30 in the fifth embodiment, all functions other than the function of the usage condition setting unit 104 can be consolidated into the charging station 20.

In addition, this embodiment has the same functions and advantages as in the first embodiment.

### (Seventh Embodiment)

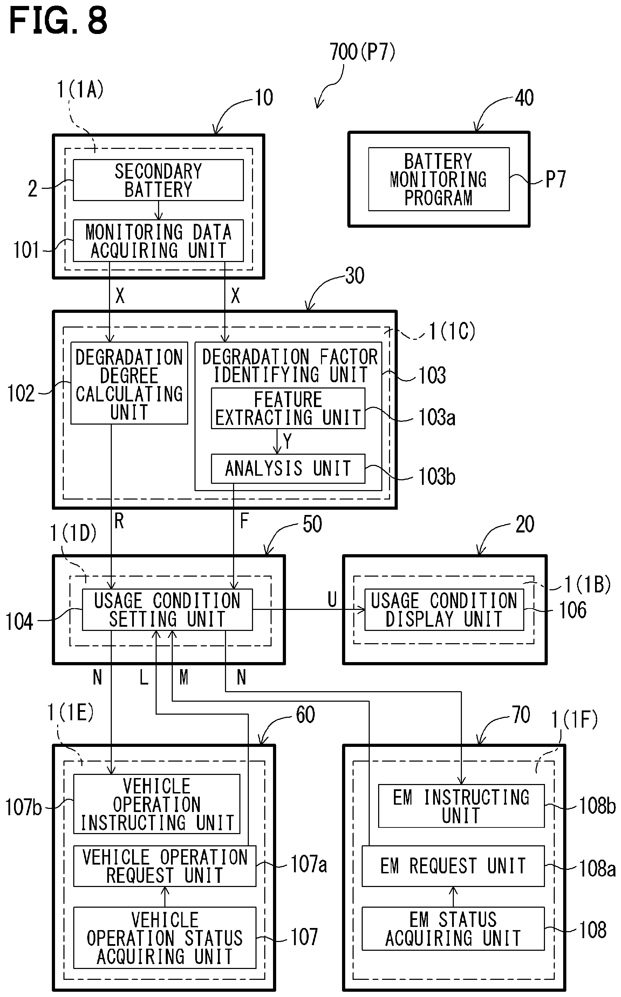

As shown in FIG. 8, a battery monitoring system 700 of the seventh embodiment differs from the battery monitoring system 500 of the fifth embodiment in that the battery monitoring system 700 further includes a battery usage condition management server 50, a vehicle operation management server 60, and an energy management server 70. The usage condition setting unit 104 is provided in the battery usage condition management server 50 instead of the battery monitoring server 30.

In the battery usage condition management server 50, the usage condition setting unit 104 has a function of determining optimal battery usage based on the state of the secondary battery 2 (the calculation result R of the degradation degree and the degradation factor F) obtained from the battery monitoring server 30, a request from a vehicle operation request unit 107a, which will be described later, and a request from an EM request unit 108a, which will be described later. In addition, the usage condition setting unit 104 has a function of outputting the determination result of the optimal battery usage to the usage condition display unit 106, and returning the determination result to the vehicle operation management server 60 and the energy management server 70. These functions of the usage condition setting unit 104 are executed by a processor 1D mounted on the battery usage condition management server 50.

The vehicle operation management server 60 includes a vehicle operation status acquiring unit 107, the vehicle operation request unit 107a, and a vehicle operation instruction unit 107b. The vehicle operation status acquiring unit 107 has a function of acquiring the actual vehicle operation status from a manager or management system of the vehicle operation status (hereinafter referred to as a "vehicle operation management unit"). The vehicle operation request unit 107a has a function of deriving a method for efficiently operating the vehicle based on the actual vehicle operation status acquired by the vehicle operation status acquiring unit 107, and outputting a battery usage request L for that operation to the usage condition setting unit 104 of the battery usage condition management server 50. The vehicle operation instruction unit 107b has a function of instructing or proposing to the vehicle operation management unit the vehicle operation based on the optimum battery usage determination result N output by the usage condition setting unit 104. The functions of the vehicle operation status acquiring unit 107, the vehicle operation request unit 107a, and the vehicle operation instruction unit 107b are executed by a processor 1E mounted on the vehicle operation management server 60.

The energy management server 70 includes an EM status acquiring unit 108, the EM request unit 108a, and an EM instruction unit 108b. Here, the term "energy management" is also referred to as "EM" for convenience. The EM status acquiring unit 108 has a function of acquiring the actual energy management status from a manager or management system of the energy management status of the power system or facility (hereinafter referred to as the "EM unit"). The EM request unit 108a has a function of deriving a method for optimizing energy management based on the actual energy management status acquired by the EM status acquiring unit 108, and outputting a battery usage request M aimed at the optimization to the usage condition setting unit 104 of the battery usage condition management server 50. The EM instruction unit 108b has a function of instructing or proposing to the EM unit energy management based on the optimum battery usage determination result N output by the usage condition setting unit 104. The functions of the EM status acquiring unit 108, the EM request unit 108a, and the EM instruction unit 108b are executed by a processor 1F mounted on the energy management server 70.

The function of each component of the battery monitoring system 700 is realized by a battery monitoring program P7. The battery monitoring program P7 is a program configured to cause the processors 1 (processors 1A, 1B, 1C, 1D, 1E, and 1F) to realize functions similar to those of the battery monitoring program P5 of the fifth embodiment. The battery monitoring program P7 is preferably recorded on the recording medium 40 in a readable manner as necessary.

The other configurations and the control are similar to those of the fifth embodiment.

According to the seventh embodiment, it is possible to determine optimal battery usage by taking into consideration the state of the secondary battery 2 as well as the operating status of the vehicle and the energy management status of the power system or facility.

In addition, this embodiment has the same functions and advantages as in the first embodiment.

In a modified example particularly related to the battery monitoring system 700 of the seventh embodiment, the usage condition setting unit 104 of the battery usage condition management server 50 may be configured to perform both the functions of the vehicle operation request unit 107a and the EM request unit 108a. In another modified example, some of the functions of the vehicle operation management server 60 may be executed by the vehicle operation management unit, and some of the functions of the energy management server 70 may be executed by the EM unit. Furthermore, in another modified example, either the vehicle operation management server 60 or the energy management server 70 may be omitted.

### (Eighth Embodiment)

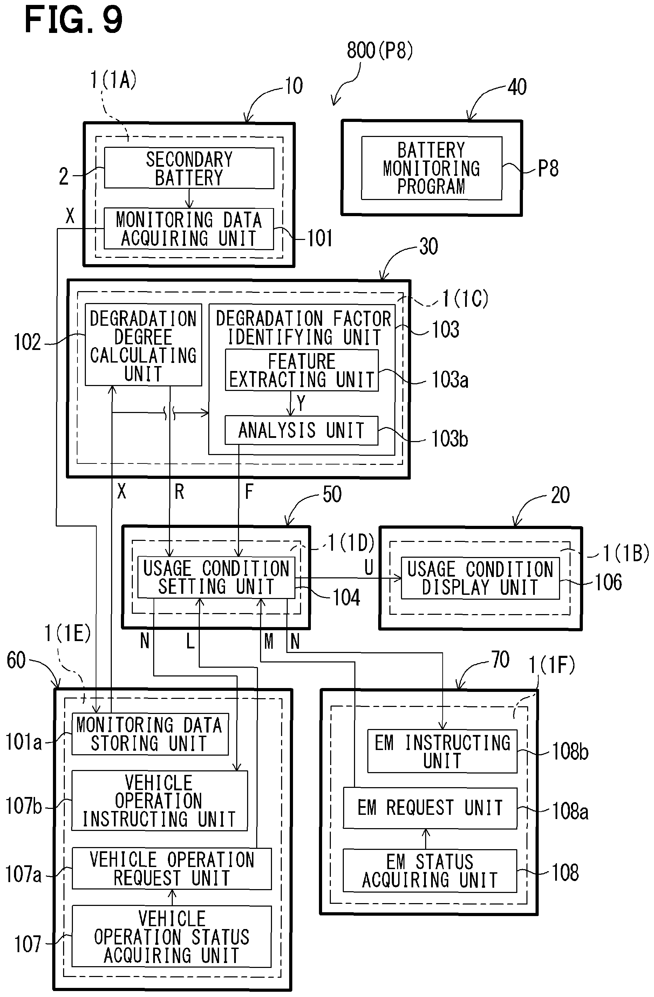

As shown in FIG. 9, a battery monitoring system 800 of the eighth embodiment differs from the battery monitoring system 700 of the seventh embodiment in that the vehicle operation management server 60 includes the monitoring data storage unit 101a. The monitoring data storage unit 101a has a function of storing the monitoring data X acquired by the monitoring data acquiring unit 101 before the data is output to the degradation degree calculating unit 102 and the degradation factor identifying unit 103 of the battery monitoring server 30.

The function of each component of the battery monitoring system 800 is realized by a battery monitoring program P8. The battery monitoring program P8 is a program configured to cause the processors 1 (processors 1A, 1B, 1C, 1D, 1E, and 1F) to realize functions similar to those of the battery monitoring program P7 of the seventh embodiment. The battery monitoring program P8 is preferably recorded on the recording medium 40 in a readable manner as necessary.

The other configurations and the control are the same as those of the seventh embodiment.

According to the eighth embodiment, the monitoring data X acquired by the monitoring data acquiring unit 101 can be stored in the vehicle operation management server 60.

In addition, this embodiment has similar functions and advantages as those in the seventh embodiment.

### (Ninth Embodiment)

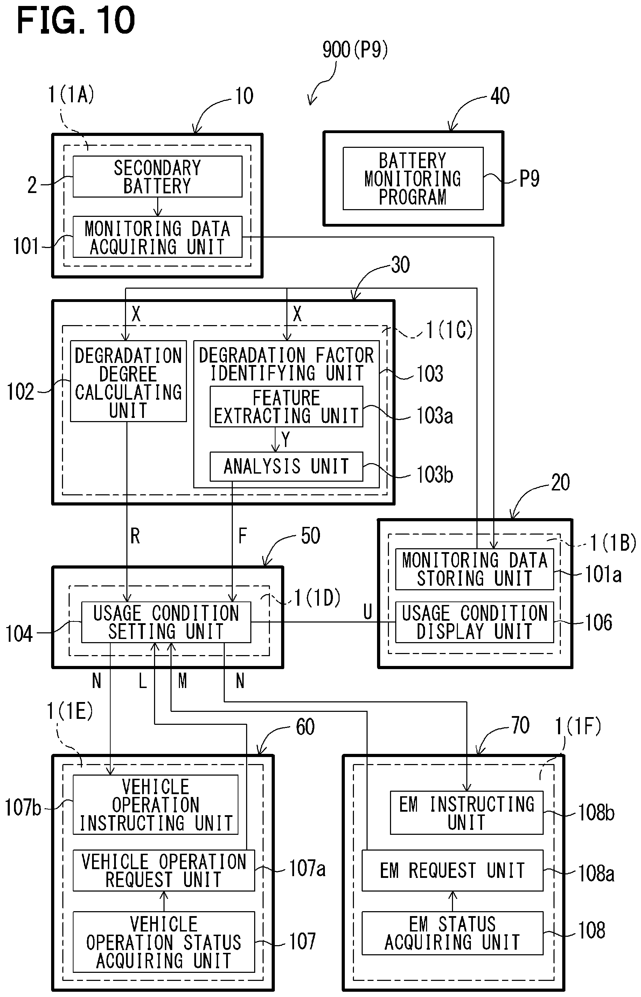

As shown in FIG. 10, a battery monitoring system 900 of the ninth embodiment differs from the battery monitoring system 800 of the eighth embodiment in that the charging station 20 includes the monitoring data storage unit 101a. The monitoring data storage unit 101a has a function of storing the monitoring data X acquired by the monitoring data acquiring unit 101 before the data is output to the degradation degree calculating unit 102 and the degradation factor identifying unit 103 of the battery monitoring server 30.

The function of each component of the battery monitoring system 900 is realized by a battery monitoring program P9. The battery monitoring program P9 is a program configured to cause the processors 1 (processors 1A, 1B, 1C, 1D, 1E, and 1F) to realize functions similar to those of the battery monitoring program P7 of the seventh embodiment. The battery monitoring program P9 is preferably recorded on the recording medium 40 in a readable manner as necessary.

The other configurations and the control are the same as those of the seventh embodiment.

According to the ninth embodiment, the monitoring data X acquired by the monitoring data acquiring unit 101 can be stored in the charging station 20.

In addition, this embodiment has similar functions and advantages as those in the seventh embodiment.

Although the present disclosure has been described in accordance with the embodiments, it is understood that the present disclosure is not limited to such embodiments or structures. The present disclosure encompasses various modifications and variations within the scope of equivalents. In addition, various combinations and forms, as well as other combinations and forms that include only one element, more than one element, or fewer elements, are also within the sprit and the scope of the present disclosure. For example, the following embodiments can be implemented by applying the above-mentioned embodiments.

In the above embodiment, the case where the usage condition U is displayed has been exemplified, but the process of displaying the usage condition U may be omitted as necessary. The program used in this case is sufficient if it causes the processor 1 to realize at least the following functions: acquiring monitoring data X of the secondary battery; calculating the degradation degree of the secondary battery 2 based on the monitoring data X; identifying the degradation factor F based on the monitoring data X when it is determined that the secondary battery 2 has degraded based on the calculation result R of the degradation degree; and setting the usage condition U of the secondary battery 2 based on the degradation factor F.

In the above-described embodiments, an example is shown in which the usage condition U is set based on both the calculation result R of the degradation degree of the secondary battery 2 and the degradation factor F. However, instead of this, the usage condition U may be set based only on the degradation factor F of the secondary battery 2 without calculating the degradation degree of the secondary battery 2. The program used in this case is sufficient if the program enables the processor 1 to realize at least the function of setting the usage condition U of the secondary battery 2 based on the degradation factor F of the secondary battery 2.

In the above embodiments, an example is shown in which monitoring data X of the secondary battery 2 is acquired and the usage condition U are set based on the degradation factor F identified from the monitoring data X. However, instead of this, the usage condition U may be set directly from the degradation factor F identified in advance.

### <Display Program>

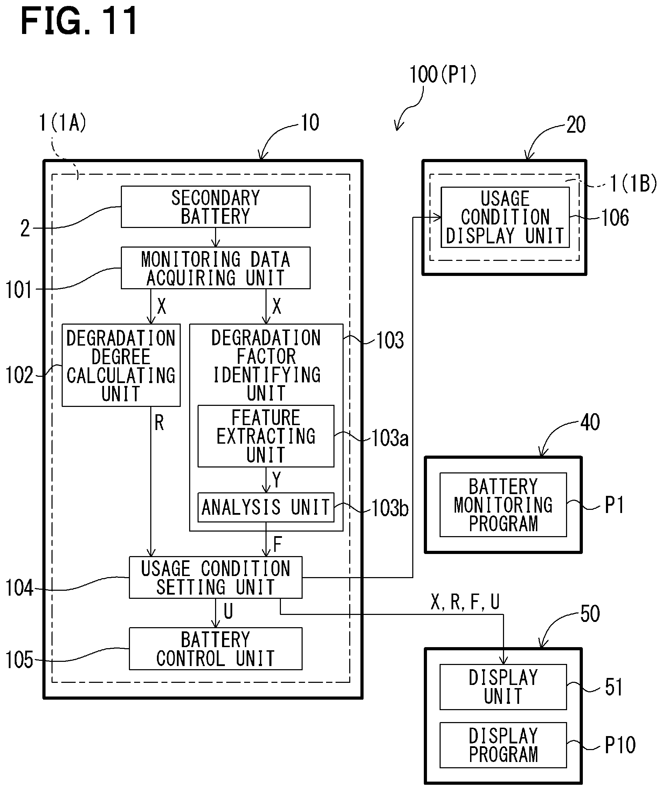

The battery monitoring program according to this embodiment includes at least a part of a display program P10 (see FIG. 11) which is described as a technical concept to be described later. Alternatively, the display program P10 may be separate from the battery monitoring program. The display program P10 is recorded in a non-transitory storage medium of the charging station 20. The display program P10 displays information to the user on the usage condition display unit 106 of the charging station 20.

In addition, the display program P10 may be downloaded from a cloud server or the like to a user's owned device 50, such as a desktop or notebook personal computer (PC), a tablet terminal, or a mobile terminal. The display program P10 may then display information to the user on the screen of the device 50. In this case, for example, a display unit 51 shown in FIG. 11 corresponds to a screen of the device 50. The display program P10 may be stored in a cloud server.

### [Technical Idea 1]

A display program (P10) configured to cause a processor (1) to display a degradation factor (F) of a secondary battery (2) and a usage condition of the secondary battery on a display unit (51).

### [Technical Idea 2]

The display program according to technical idea 1 configured to cause the processor to display, on the display unit, monitoring data of the secondary battery to identify the degradation factor of the secondary battery.

### [Technical Idea 3]

The display program according to technical Idea 1 or 2 configured to cause the processor to display, on the display unit, a calculation result (R) of the degradation degree of the secondary battery.

## Claims

1. A battery monitoring program (P1, P2, P3, P4, P5, P6, P7, P8, P9) configured to cause at least one processor (1) to set a usage condition (U) of a secondary battery (2) based on a degradation factor (F) of the secondary battery.

2. The battery monitoring program according to claim 1 further configured to cause the at least one processor to:
acquire monitoring data (X) of the secondary battery; and
identify the degradation factor based on the acquired monitoring data.

3. The battery monitoring program according to claim 2, further configured to cause the at least one processor to:
calculate a degradation degree of the secondary battery based on the acquired monitoring data to obtain a calculation result; and
set the usage condition based on the calculation result of the degradation degree and the degradation factor.

4. The battery monitoring program according to claim 3, further configured to cause the at least one processor to:
calculate the degradation degree of the secondary battery based on the acquired monitoring data; and
set the usage condition based on the calculation result of the degradation degree, the degradation factor, and at least one of an operational status of a vehicle and an energy management status of a power system or a facility.

5. The battery monitoring program according to claim 1, further configured to cause the at least one processor to display the set usage condition.

6. A recording medium (40) configured to store the battery monitoring program according to any one of claims 1 to 5 in a readable manner.

7. A battery monitoring system (100, 200, 300, 400, 500, 600, 700, 800, 900) to monitor a secondary battery (2), the battery monitoring system comprising
a usage condition setting unit (104) configured to set a usage condition (U) of the secondary battery based on a degradation factor (F) of the secondary battery.

8. The battery monitoring system according to claim 7, further comprising:
a monitoring data acquiring unit (101) configured to acquire monitoring data of the secondary battery; and
a degradation factor identifying unit (103) configured to identify the degradation factor based on the monitoring data acquired by the monitoring data acquiring unit.

9. The battery monitoring system according to claim 8, further comprising
a degradation degree calculating unit (102) configured to calculate a degradation degree of the secondary battery based on the monitoring data acquired by the monitoring data acquiring unit to obtain a calculation result (R), wherein
the usage condition setting unit is configured to set the usage condition based on the calculation result obtained by the degradation degree calculating unit and the degradation factor identified by the degradation factor identifying unit.

10. The battery monitoring system according to claim 9, wherein
the usage condition setting unit is configured to set the usage condition based on the calculation result (R) of the degradation degree obtained by the degradation degree calculating unit, the degradation factor identified by the degradation factor identifying unit, and at least one of an operational status of a vehicle and an energy management status of a power system or a facility.

11. The battery monitoring system according to any one of claims 7 to 10, further comprising
a usage condition display unit (106) configured to display the usage condition set by the usage condition setting unit.
